# EUROPEAN PATENT SPECIFICATION

(11) **EP 3 200 254 B1**
(45) Date of publication and mention of the grant of the patent: **07.06.2023**
(21) Application number: 15845488.4
(22) Date of filing: 18.09.2015
(51) Int. Cl.: H01L 51/52

(54) **LIGHT EXTRACTION SUBSTRATE FOR ORGANIC LIGHT EMITTING ELEMENT AND ORGANIC LIGHT EMITTING ELEMENT COMPRISING SAME**
LICHTEXTRAKTIONSSUBSTRAT FÜR ORGANISCHES LICHTEMITTIERENDES ELEMENT UND ORGANISCHES LICHTEMITTIERENDES ELEMENT DAMIT
SUBSTRAT D'EXTRACTION DE LUMIÈRE POUR ÉLÉMENT ÉLECTROLUMINESCENT ORGANIQUE, ET ÉLÉMENT ÉLECTROLUMINESCENT ORGANIQUE COMPRENANT LEDIT SUBSTRAT

(30) Priority: 25.09.2014 KR 20140128197; 29.12.2014 KR 20140192272
(43) Date of publication of application: 02.08.2017
(73) Proprietor: Corning Precision Materials Co., Ltd., Asan-si, Chungcheongnam-do 336-841 (KR)
(72) Inventor: YOON, Hong, Asan-si Chungcheongnam-do 336-841 (KR); LEE, Joo Young, Asan-si Chungcheongnam-do 336-841 (KR); LEE, Hyun Hee, Asan-si Chungcheongnam-do 336-841 (KR); KIM, Dong Hyun, Asan-si Chungcheongnam-do 336-841 (KR); KIM, Min Seok, Asan-si Chungcheongnam-do 336-841 (KR); KIM, Seo Hyun, Asan-si Chungcheongnam-do 336-841 (KR); WOO, Kwang Je, Asan-si Chungcheongnam-do 336-841 (KR)
(74) Representative: Gulde & Partner
(86) International application number: PCT/KR2015/009802
(87) International publication number: WO 2016/047970

(56) References cited:
- WO-A1-2013/141674
- WO-A1-2013/147573
- CN-A- 104 039 905
- JP-A- 2005 353 367
- KR-A- 20140 032 471
- KR-A- 20140 046 728
- KR-A- 20140 108 434
- KR-B1- 101 114 916

## Description

### TECHNICAL FIELD

The present disclosure relates to a light extraction substrate for an organic light-emitting diode (OLED) device and an OLED device including the same. More particularly, the present disclosure relates to a light extraction substrate for an OLED device, the light extraction substrate having an optimized multilayer structure that can maximize scattering efficiency to improve the light extraction efficiency of the OLED device, and an OLED device including the same.

### BACKGROUND ART

In general, light-emitting devices may be divided into organic light-emitting diode (OLED) devices having a light-emitting layer formed from an organic material and inorganic light-emitting devices having a light-emitting layer formed from an inorganic material. In OLED devices, OLEDs are self-emitting light sources based on the radiative decay of excitons generated in an organic light-emitting layer by the recombination of electrons injected through an electron injection electrode (cathode) and holes injected through a hole injection electrode (anode). OLEDs have a range of merits, such as low-voltage driving, self-emission, a wide viewing angle, high resolution, natural color reproducibility, and rapid response times.

Recently, research has been actively undertaken into applying OLEDs to portable information devices, cameras, clocks or watches, office equipment, information display devices for vehicles or the like, televisions (TVs), display devices, lighting systems, and the like.

To improve the luminous efficiency of such above-described OLED devices, it is necessary to improve the luminous efficiency of a material of which a light-emitting layer is formed or light extraction efficiency, i.e. the efficiency with which light generated by the light-emitting layer is extracted.

The light extraction efficiency of an OLED device depends on the refractive indices of OLED layers. In a typical OLED device, when a beam of light generated by the light-emitting layer is emitted at an angle greater than a critical angle, the beam of light may be totally reflected at the interface between a higher-refractivity layer, such as a transparent electrode layer acting as an anode, and a lower-refractivity layer, such as a glass substrate. This may consequently lower light extraction efficiency, thereby lowering the overall luminous efficiency of the OLED device, which is problematic.

Described in more detail, only about 20% of light generated by an OLED is emitted from the OLED device and about 80% of the light generated is lost due to a waveguide effect originating from different refractive indices of a glass substrate, an anode, and an organic light-emitting layer comprised of a hole injection layer, a hole transport layer, an emissive layer, an electron transport layer, and an electron injection layer, as well as by the total internal reflection originating from the difference in refractive indices between the glass substrate and ambient air. Here, the refractive index of the internal organic light-emitting layer ranges from 1.7 to 1.8, whereas the refractive index of indium tin oxide (ITO), generally used in anodes, is about 1.9. Since the two layers have a significantly low thickness, ranging from 200 nm to 400 nm, and the refractive index of the glass used for the glass substrate is about 1.5, a planar waveguide is thereby formed inside the OLED device. It is calculated that the ratio of the light lost in the internal waveguide mode due to the above-described reason is about 45%. In addition, since the refractive index of the glass substrate is about 1.5 and the refractive index of ambient air is 1.0, when light exits the interior of the glass substrate, a beam of the light, having an angle of incidence greater than a critical angle, may be totally reflected and trapped inside the glass substrate. The ratio of trapped light is about 35%. Therefore, only about 20% of generated light may be emitted from the OLED device.

To overcome such problems, light extraction layers through which 80% of light that would otherwise be lost in the internal waveguide mode can be extracted have been actively researched. Light extraction layers are generally categorized as internal light extraction layers and external light extraction layers. In the case of external light extraction layers, it is possible to improve light extraction efficiency by disposing a film including microlenses on the outer surface of the substrate, the shape of the microlenses being selected from a variety of shapes. The improvement of light extraction efficiency does not significantly depend on the shape of microlenses. On the other hand, internal light extraction layers directly extract light that would otherwise be lost in the light waveguide mode. Thus, the capability of internal light extraction layers to improve light extraction efficiency may be higher than that of external light extraction layers. However, an internal light extraction layer may act contrary to this intention, when the angle of incident light is substantially perpendicular to the glass substrate. Although an internal light extraction layer may have higher light extraction efficiency than an external light extraction layer, such an internal light extraction layer may cause light loss. In addition, an internal light extraction layer must be formed during the fabrication process of an OLED device, is influenced by subsequent processing, and is difficult to form in technological terms, which are problematic.

There has been significant development in light extraction technology based on a light scattering phenomenon. In particular, internal light extraction technology, in which a light-scattering layer is sandwiched between a substrate and a transparent electrode to form an internal light extraction layer, has come to prominence. In this case, the light efficiency improving performance of the internal light extraction layer is mainly dependent on scattering efficiency produced by the scattering structure of light-scattering elements contained in the light-scattering layer. At present, active research is being undertaken into further improving scattering efficiency.

WO 2013/147573 A1, WO 201 3/141 674 A1, and CN 104 039 905 (A) are relevant prior art.

### DISCLOSURE

### Technical Problem

Accordingly, the present disclosure has been made in consideration of the above problems occurring in the related art, and the present disclosure proposes a light extraction substrate for an organic light-emitting diode (OLED) device, the light extraction substrate having an optimized multilayer structure that can maximize scattering efficiency to improve the light extraction efficiency of the OLED device, and an OLED device including the same.

### Technical Solution

According to an aspect of the present disclosure, a light extraction substrate for an organic light-emitting diode (OLED) device is provided as defined in claim 1.

Further, according to an aspect of the present disclosure, an organic light-emitting diode device is provided as defined in claim 8.

Further embodiments are provided in the dependent claims.

### Advantageous Effects

According to the present disclosure, at least one layer from among a number of light-scattering elements, a cover matrix, and a planarization layer is provided as a different refractive index layer. More particularly, since the cover matrix may have a higher refractive index than the number of light-scattering elements and the planarization layer and the thickness of the cover matrix having a higher refractive index can be controlled, the multilayer structure can be optimized to maximize scattering efficiency. It is thereby possible to improve the light extraction efficiency of an OLED device.

### DESCRIPTION OF DRAWINGS

FIG. 1 is a conceptual cross-sectional view illustrating an OLED device including a light extraction substrate according to an exemplary embodiment disposed in a portion thereof, through which light generated by an OLED exits;
FIG. 2 is a graph illustrating results of optical analysis for an OLED device including a light extraction substrate according to an exemplary embodiment;
FIG. 3 illustrates modeling results for five types of internal light extraction layers having different packing densities (PD) of light-scattering elements;
FIG. 4 is a graph illustrating light extraction efficiencies according to packing densities of light-scattering elements, compared to the modeling results in FIG. 3; and
FIG. 5 is a scanning electron microscope (SEM) image taken from a matrix layer formed from rutile TiO₂.

### MODE FOR INVENTION

Hereinafter, a light extraction substrate for an organic light-emitting diode (OLED) device and an OLED device including the same will be described in detail with reference to the accompanying drawings.

In the following description, detailed descriptions of known functions and components incorporated herein will be omitted in the case that the subject matter of the present disclosure may be rendered unclear by the inclusion thereof.

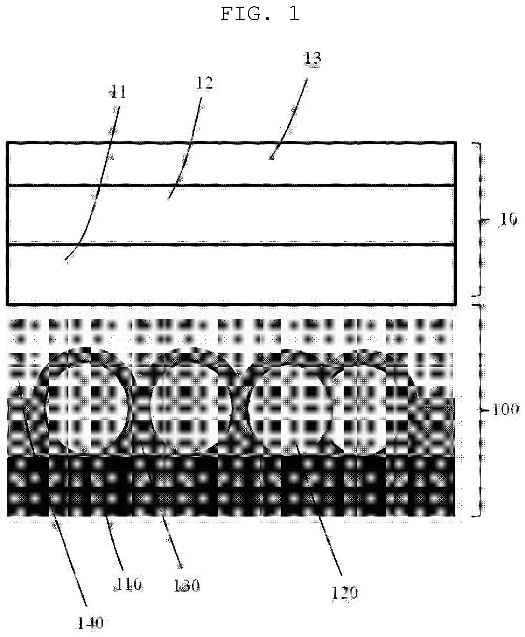

As illustrated in FIG. 1, a light extraction substrate 100 for an OLED device according to an exemplary embodiment is a functional substrate serving to improve the light extraction efficiency of an OLED device to improve the luminance of a lighting device in which the OLED device is used. The light extraction substrate 100 is disposed in a portion of the OLED device through which light generated by an OLED 10 exits.

The OLED 10 has a multilayer structure sandwiched between the light extraction substrate 100 according to the exemplary embodiment and another substrate (not shown) facing the light extraction substrate 100 to encapsulate the OLED 10. The multilayer structure of the OLED is comprised of a first electrode 11, an organic light-emitting layer 12, and a second electrode 13. The first electrode 11 is an electrode acting as an anode of the OLED 10. The first electrode 11 may be formed from, for example, a metal, such as Au, In, or Sn, or a metal oxide, such as indium tin oxide (ITO), having a greater work function to facilitate hole injection. The second electrode 13 is an electrode acting as a cathode of the OLED 10. The second electrode 13 may be a metal thin film formed from Al, Al:Li or Mg:Ag that has a lower work function to facilitate electron injection. Although not specifically illustrated, the organic light-emitting layer 12 is comprised of a hole injection layer, a hole transport layer, an emission layer, an electron transport layer, and an electron injection layer that are sequentially stacked on the first electrode 11 acting as the anode.

According to this structure, when a forward voltage is induced between the first electrode 11 acting as the anode and the second electrode 13 acting as the cathode, electrons migrate from the second electrode 13 to the emission layer through the electron injection layer and the electron transport layer, while holes migrate from the first electrode 11 to the emission layer through the hole injection layer and the hole transport layer. The electrons and the holes that have migrated into the emission layer recombine with each other, thereby generating excitons. These excitons transit from an excited state to a ground state, thereby emitting light. The brightness of the emitted light is proportional to the amount of current that flows between the first electrode 11 acting as the anode and the second electrode 13 acting as the cathode.

When the OLED 10 is a white OLED used for lighting, the light-emitting layer may have a multilayer structure comprised of a high-molecular light-emitting layer that emits blue light and a low-molecular light-emitting layer that emits orange-red light, or may have a variety of other structures that emit white light.

According to an embodiment, the organic light-emitting layer 12 may have a tandem structure. In this case, a plurality of organic light-emitting layers 12 alternating with interconnecting layers may be provided.

The light extraction substrate 100 according to the exemplary embodiment provided to improve the light extraction efficiency of the OLED device includes a base substrate 110, a number of light-scattering elements 120, a cover matrix layer 130, and a planarization layer 140.

The base substrate 110 is a substrate supporting the number of light-scattering elements 120, the cover matrix layer 130, and the planarization layer 140 disposed on one surface thereof. In addition, the base substrate 110 is disposed in the front portion of the OLED device, i.e. on one surface of the OLED 10, through which light generated by the OLED 10 exits, to allow generated light to pass therethrough while acting as an encapsulation substrate protecting the OLED 10 from the external environment.

The base substrate 110 may be any transparent substrate that has superior light transmittance and mechanical properties. For example, the base substrate 110 may be formed from a polymeric material, such as a thermally or ultraviolet (UV) curable organic film. Alternatively, the base substrate 110 may be formed from chemically strengthened glass, such as soda-lime glass (SiO₂-CaO-Na₂O) or aluminosilicate glass (SiO₂-Al₂O₃-Na₂O). When the OLED device including the OLED 10 and the light extraction substrate 100 according to the exemplary embodiment of the present disclosure is used for lighting, the base substrate 110 may be formed from soda-lime glass. The base substrate 110 may also be a metal oxide substrate or a metal nitride substrate. Alternatively, the base substrate 110 may be a flexible substrate, more particularly, a thin glass sheet having a thickness of 1.5 mm or less. The thin glass sheet may be manufactured using a fusion process or a floating process.

The number of light-scattering elements 120 are disposed on the base substrate 110. The number of light-scattering elements 120 is a number of light-scattering particles. The number of light-scattering elements 120 may be arranged or provided on the base substrate 110 by, for example, mixing a material of the cover matrix layer 130 with the number of light-scattering elements 120 in a sol-gel method and then applying the resultant mixture to the base substrate 110. Alternatively, the number of light-scattering elements 120 may be provided on the base substrate 110 before the cover matrix layer 130 is formed, by a process separate from the process of forming the cover matrix layer 130.

As described above, the number of light-scattering elements 120 according to the exemplary embodiment is a number of light-scattering particles.

The number of light-scattering elements 120 that may have a variety of shapes as described above are eventually dispersed within the cover matrix layer 130.

According to an embodiment, the number of light-scattering elements 120, more particularly, the number of light-scattering particles, may be formed from a material having the same refractive index as or a different refractive index from the cover matrix layer 130. In particular, the number of light-scattering particles may be formed from a material having a lower refractive index than the cover matrix layer 130. For example, the number of light-scattering elements 120 may be formed from a metal oxide having a lower refractive index than the cover matrix layer 130, depending on the material of the cover matrix layer 130, the metal oxide being selected from among SiO₂, TiO₂, and Al₂O₃. According to an embodiment, the number of light-scattering elements 120 may be a number of spherical nanoparticles, in particular, having a diameter of 50 nm to 1 µm.

The number of light-scattering elements 120 disposed on the base substrate 110 and dispersed within the cover matrix layer 130 form an internal light extraction layer (ILEL) for the OLED 10 together with the cover matrix layer 130 and the planarization layer 140. Specifically, the number of light-scattering elements 120 are formed from a material having a lower refractive index than the cover matrix layer 130 to form different refractive index portions from the cover matrix layer 130. This can consequently diversify paths along which light beams generated by the OLED 10 exit, thereby improving the light extraction efficiency of the OLED device. When the number of light-scattering elements 120 and the cover matrix layer 130 are formed from materials having the same refractive index, the planarization layer 140 is formed from a material having a different refractive index, thereby achieving differences in refractive index.

When the number of light-scattering elements 120 is distributed in a wider area within the cover matrix layer 130, the light extraction efficiency is more improved. Thus, the number of light-scattering elements 120 according to the exemplary embodiment have a packing density of 40% or higher within the cover matrix layer 130.

The number of light-scattering particles may have multiple refractive indices. For example, each of the number of light-scattering particles may have a core-shell structure comprised of a core and a shell that provide different refractive indices. In the core-shell structure, the core may be a hollow portion. When the number of light-scattering particles have the core-shell structure, the different refractive indices of the core and the shell can further improve the efficiency with which light generated by the OLED 10 is extracted.

In a case in which all of the number of light-scattering elements 120 are light-scattering particles, the entirety of the number of light-scattering elements 120 dispersed within the matrix layer 130 may be particles having a core-shell structure or particles having a single refractive index. Alternatively, the number of light-scattering elements 120 may be a mixture of multiple refractive particles, such as core-shell particles, each having multiple refractive indices and single refractive particles, each having a single refractive index.

The cover matrix layer 130 is a layer fixing the number of light-scattering elements 120 on the base substrate 110. In this regard, the cover matrix layer 130 is disposed on the base substrate 110 in a configuration covering the number of light-scattering elements 120 disposed on the base substrate 110.

The cover matrix layer 130 is formed from a material having a different refractive index from at least one of the number of light-scattering elements 120 and the planarization layer 140 to improve the light extraction efficiency of the OLED device based on a difference in refractive indices. In particular, the cover matrix layer 130 according to the exemplary embodiment may form a high-refractive index (HRI) matrix layer having a higher refractive index than the number of light-scattering elements 120 and the planarization layer 140. The cover matrix layer 130 is formed from rutile TiO2 In an alternative embodiment not forming part of the present invention, the cover matrix layer 130 may be formed from a combination of rutile TiO2 and a material selected from a group of metal oxides, consisting of SiO₂, TiO₂, ZrOₓ, ZnO, and SnO₂, or may be formed from HRI polymer. For example, when the number of light-scattering elements 120 are SiO₂ particles, the cover matrix layer 130 may be formed from TiO₂ having a refractive index of 2.3.

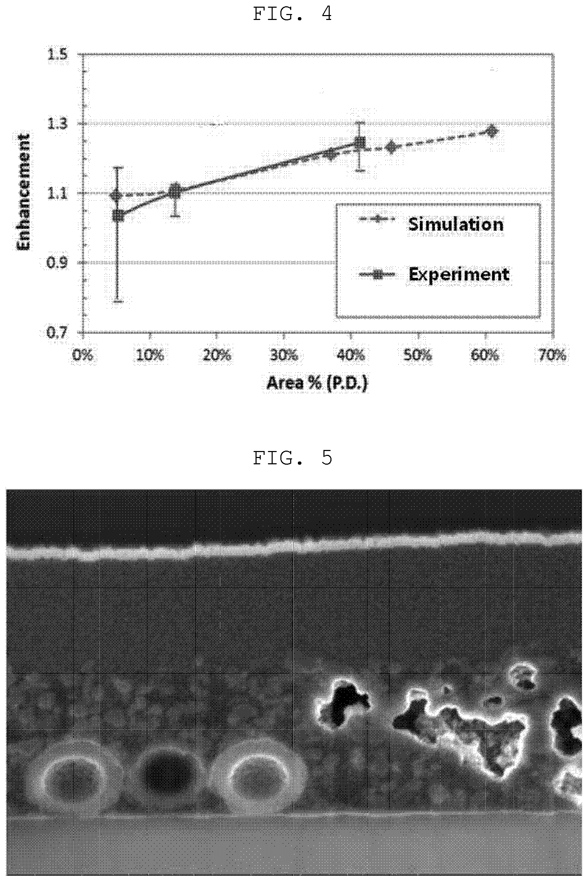

As illustrated in the scanning electron microscope (SEM) image in FIG. 5, when the cover matrix layer 130 is formed from rutile TiO₂, a number of irregular-shaped voids having sizes of about 50 nm to about 900 nm are formed within TiO₂, during a TiO₂ firing process for forming the cover matrix layer 130. The number of voids form a complicated light-scattering structure together with the number of light-scattering elements 120, thereby improving the light extraction efficiency of the OLED device. The number of voids can produce a light-scattering effect equal to or higher than the number of light-scattering elements 120. The more irregular-shaped voids are formed within the cover matrix layer 130 formed from rutile TiO₂, i.e. the greater the area occupied by the number of voids in the cover matrix layer 130 is, the greater the degree of light extraction efficiency is. As described above, the increased number of voids formed within the cover matrix layer 130 can decrease the required amount of relatively expensive light-scattering elements 120, thereby reducing manufacturing costs.

According to an embodiment, not forming part of the present invention, the cover matrix layer 130, formed of an HRI matrix layer having a higher refractive index than the number of light-scattering elements 120 and the planarization layer 140 as described above, may have a thickness smaller than the thickness, i.e. the diameter, of the number of light-scattering elements 120. Thus, according to an embodiment, the cover matrix layer 130 may be formed at a thickness of 10 nm to 500 nm. As illustrated in the drawings, when the cover matrix layer 130 is formed in this thickness range, the number of light-scattering elements 120 form an array of convex lenses on the surface of the cover matrix layer 130. The array of lenses diversifies the paths of light beams generated by the OLED 10, like the number of light-scattering elements 120, thereby improving the light extraction efficiency of the OLED device. According to the exemplary embodiment, the optimized multilayer structure comprised of the number of light-scattering elements 120 and the cover matrix layer 130 can maximize the scattering efficiency of light generated by the OLED 10, thereby improving the light extraction efficiency of the OLED device. The planarization layer 140 is disposed on the cover matrix layer 130. The planarization layer 140 forms the internal light extraction layer (ILEL) of the OLED 10 together with the cover matrix layer 130 and the number of light-scattering elements 120 dispersed within the cover matrix layer 130. The surface of the planarization layer 140 formed on the cover matrix layer 130 abuts the OLED 10, more particularly, the first electrode 11 of the OLED 10 acting as the anode of the OLED 10. Since the surface of the planarization layer 140 abuts the first electrode 11, i.e. the transparent electrode acting as the anode of the OLED 10, as described above, the surface of the planarization layer 140 is required to be a high flat surface to prevent the electrical characteristics of the OLED 10 from degrading. When the planarization layer 140 is formed on the cover matrix layer 130, the array of lenses formed on the surface of the cover matrix layer 130 due to the number of light-scattering elements 120 may impart textured features to the surface of the planarization layer 140. To prevent this problem, the planarization layer 140 may be formed at a sufficient thickness such that the surface thereof is not influenced by the array of lenses. Thus, according to an embodiment, the thickness of the planarization layer 140 may range from 50 nanometers to several micrometers.

According to an embodiment, the planarization layer 140 may be formed from a material having the same refractive index as or a different refractive index from the cover matrix layer 130 to maximize the light extraction efficiency of the OLED device. For example, when the planarization layer 140 is formed from a material having a different refractive index from the cover matrix layer 130, the planarization layer 140 may be formed from a metal oxide, such as SiO₂ or TiO₂, or HRI polymer. Here, materials selectable for the planarization layer 140 are limited to materials having a lower refractive index than the material of the cover matrix layer 130. In this case, the planarization layer 140 may be formed from a material having the same refractive index as the number of light-scattering elements 120. However, according to the exemplary embodiment, the material of the planarization layer 140 is not specifically limited to the same material as the number of light-scattering elements 120, since the planarization layer 140 is only required to be formed from a material having a lower refractive index than the cover matrix layer 130 such that the refractive index thereof differs from the refractive index of the cover matrix layer 130. For example, when the planarization layer 140 and the number of light-scattering elements 120 are formed from materials having lower refractive indices than the cover matrix layer 130, the refractive index of the planarization layer 140 may be different from the refractive index of the number of light-scattering elements 120. That is, the planarization layer 140 may be formed from a material having a different refractive index from the number of light-scattering elements 120.

Accordingly, in the light extraction substrate 100 for an OLED according to the exemplary embodiment, at least one layer from among the number of light-scattering elements 120, the cover matrix layer 130, and the planarization layer 140 is provided as a different refractive index layer.

When the internal light extraction layer having a multiple refractive index multilayer structure, such as a low/high refractive index structure, a high/low refractive index structure, or a low/high/low refractive index structure, is provided on a path, along which light generated by the OLED 10 exits, different refractive index layers can improve the efficiency with which light generated by the OLED 10 is extracted. The multilayer structure of the internal light extraction layer serves to increase the effect of improving the light extraction efficiency of the OLED device, based on the improved light scattering effect produced by the array of lenses of the number of light-scattering elements 120 and the cover matrix layer 130.

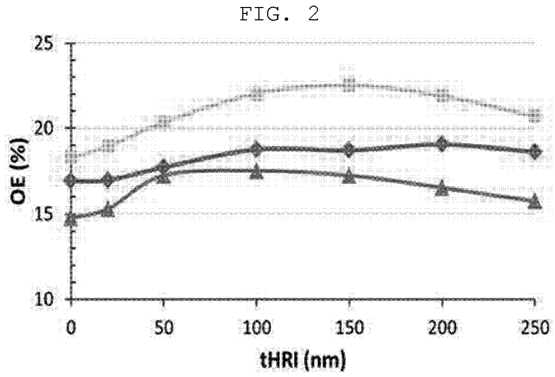

FIG. 2 is a graph illustrating results of optical analysis for an OLED device when the light extraction substrate having the above-described structure according to the exemplary embodiment is used in the OLED device. In this case, SiO₂ particles having a diameter of 200 nm were used as light-scattering elements, a cover matrix layer having a high refractive index was formed from TiO₂ having a refractive index of 2.3, a planarization layer was formed from SiO₂, the same material as of the light-scattering elements. Referring to the graph of FIG. 2, it can be appreciated that the efficiency of the OLED device varies depending on the thickness tHRI of the cover matrix layer. In particular, it can be appreciated that the efficiency of the OLED device was the highest when the thickness of the cover matrix layer was smaller than 200 nm, i.e. the diameter of the light-scattering elements. The yellow, red, and blue lines in the graph represent the wavelength-specific variations in the light extraction efficiency of the OLED device according to the thickness tHRI of the matrix layer, indicating that the thickness tHRI of the cover matrix layer exhibiting the highest efficiency according to the wavelength can be selected.

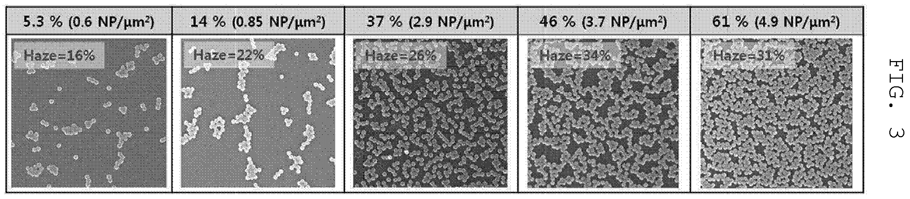

In addition, FIGS. 3 and 4 are graphs illustrating modeling and test results for five types of internal light extraction layers, in which a number of light-scattering elements have different packing densities, to determine the correlation between the packing density and the light extraction efficiency of the number of light-scattering elements distributed within a cover matrix layer. First, referring to FIG. 3, it can be appreciated that haze values increase with increases in the packing density of the number of light-scattering elements. However, when the packing density of the number of light-scattering elements exceeds 50%, the haze values decrease. In addition, referring to FIG. 4, it can be appreciated that the light extraction efficiency increases with increases in the packing density of the number of light-scattering elements.

## Claims

1. A light extraction substrate (100) for an organic light-emitting diode device, comprising:
a base substrate (110);
a number of light-scattering particles (120) disposed on the base substrate, the number of light-scattering particles producing a first light-scattering effect;
a cover matrix layer (130) disposed on the base substrate to cover the number of light-scattering particles such that the number of light-scattering particles are distributed within the cover matrix layer (130); and
a planarization layer (140) disposed on the cover matrix layer, with a surface thereof abutting an organic light-emitting diode,
wherein at least one of the number of light-scattering particles, the cover matrix layer (130), and the planarization layer (140) has a different refractive index,
wherein the cover matrix layer (130) is formed from rutile TiO2 and includes a number of irregular-shaped voids formed in the rutile TiO2, the number of irregular-shaped voids producing a second light-scattering effect, the second light-scattering effect being equal to or greater than the first light-scattering effect,
wherein sizes of the number of voids range from 50 nm to 900 nm, and
the number of light-scattering particles have a packing density of 40% or more within the cover matrix layer.

2. The light extraction substrate of claim 1, wherein a thickness of the cover matrix layer (130) ranges from 10 nm to 500nm and diameters of the number of light-scattering particles range from 50 nm to 1 µm, and wherein the thickness of the cover matrix layer (130) is less than the diameters of the number of light-scattering particles.

3. The light extraction substrate of claim 1, wherein each of the number of light-scattering particles has a single refractive index or multiple refractive indices.

4. The light extraction substrate of claim 3, wherein the number of light-scattering particles comprise a combination of single refractive particles having a single refractive index and multiple refractive particles having multiple refractive indices.

5. The light extraction substrate of claim 4, wherein each of the multiple refractive particles comprises a core and a shell surrounding the core, the shell having a different refractive index from the core.

6. The light extraction substrate of claim 1, wherein the base substrate (110) comprises a thin glass sheet having a thickness of 1.5 mm or less.

7. An organic light-emitting diode device comprising:
a cathode (13);
an organic light-emitting layer (12) stacked on the cathode;
an anode (11) stacked on the organic light-emitting layer; and
the light extraction substrate, as claimed in claim 1, disposed on the anode,
wherein the planarization layer (140) abuts the anode (11), and
wherein the planarization layer, the number of light-scattering particles, and the cover matrix layer (130) form an internal light extraction layer.

## Patentansprüche

1. Ein Lichtauskopplungssubstrat (100) für eine organische Leuchtdiodenvorrichtung, umfassend:
ein Basissubstrat (110);
eine Anzahl von lichtstreuenden Partikeln (120), die auf dem Basissubstrat angeordnet sind, wobei die Anzahl der lichtstreuenden Partikel einen ersten Lichtstreueffekt erzeugt;
eine Deckmatrixschicht (130), die auf dem Basissubstrat angeordnet ist, um die Anzahl der lichtstreuenden Teilchen zu bedecken, so dass die Anzahl der lichtstreuenden Teilchen innerhalb der Deckmatrixschicht (130) verteilt ist; und
eine Planarisierungsschicht (140), die auf der Deckmatrixschicht angeordnet ist, wobei eine Oberfläche davon an eine organische Leuchtdiode angrenzt,
wobei mindestens eine der Anzahl von lichtstreuenden Partikeln, der Deckmatrixschicht (130) und der Planarisierungsschicht (140) einen unterschiedlichen Brechungsindex aufweist,
wobei die Deckmatrixschicht (130) aus Rutil-TiO2 gebildet ist und eine Anzahl von unregelmäßig geformten Hohlräumen enthält, die in dem Rutil-TiO2 gebildet sind, wobei die Anzahl von unregelmäßig geformten Hohlräumen einen zweiten Lichtstreueffekt erzeugt, wobei der zweite Lichtstreueffekt gleich oder größer als der erste Lichtstreueffekt ist,
wobei die Größe der Anzahl der Hohlräume zwischen 50 nm und 900 nm liegt, und
die Anzahl der lichtstreuenden Teilchen eine Packungsdichte von 40 % oder mehr innerhalb der Deckmatrixschicht aufweist.

2. Lichtextraktionssubstrat nach Anspruch 1, wobei die Dicke der Deckmatrixschicht (130) im Bereich von 10 nm bis 500 nm liegt und die Durchmesser der Anzahl der lichtstreuenden Teilchen im Bereich von 50 nm bis 1 um liegen, und wobei die Dicke der Deckmatrixschicht (130) geringer ist als die Durchmesser der Anzahl der lichtstreuenden Teilchen.

3. Lichtauskopplungssubstrat nach Anspruch 1, wobei jedes der lichtstreuenden Teilchen einen einzigen Brechungsindex oder mehrere Brechungsindizes aufweist.

4. Lichtauskopplungssubstrat nach Anspruch 4, wobei die Anzahl der lichtstreuenden Teilchen eine Kombination aus einzelnen brechenden Teilchen mit einem einzigen Brechungsindex und mehrfach brechenden Teilchen mit mehreren Brechungsindizes umfasst.

5. Lichtauskopplungssubstrat nach Anspruch 5, wobei jedes der mehrfach brechenden Teilchen einen Kern und eine den Kern umgebende Hülle umfasst, wobei die Hülle einen anderen Brechungsindex als der Kern aufweist.

6. Das Lichtauskopplungssubstrat nach Anspruch 1, wobei das Basissubstrat (110) eine dünne Glasplatte mit einer Dicke von 1,5 mm oder weniger umfasst.

7. Organische lichtemittierende Diode, umfassend:
eine Kathode (13);
eine organische lichtemittierende Schicht (12), die auf die Kathode aufgebracht ist;
eine Anode (11), die auf die organische lichtemittierende Schicht gestapelt ist; und
das Lichtauskopplungssubstrat nach Anspruch 1, das auf der Anode angeordnet ist,
wobei die Planarisierungsschicht (140) an der Anode (11) anliegt, und
wobei die Planarisierungsschicht, die Anzahl der lichtstreuenden Partikel und die Deckmatrixschicht (130) eine interne Lichtextraktionsschicht bilden.

## Revendications

1. Substrat d'extraction de lumière (100) pour un dispositif de diode électroluminescente organique, comprenant :
un substrat de base (110) ;
un nombre de particules de diffusion de la lumière (120) disposées sur le substrat de base, le nombre de particules de diffusion de la lumière produisant un premier effet de diffusion de la lumière ;
une couche de matrice de couverture (130) disposée sur le substrat de base pour couvrir le nombre de particules de diffusion de la lumière de telle sorte que le nombre de particules de diffusion de la lumière soit distribué dans la couche de matrice de couverture (130) ; et
une couche de planarisation (140) disposée sur la couche de matrice de couverture, dont une surface est en contact avec une diode électroluminescente organique,
dans lequel au moins l'un du nombre de particules diffusant la lumière, de la couche de matrice de couverture (130) et de la couche de planarisation (140) a un indice de réfraction différent,
dans lequel la couche de matrice de couverture (130) est formée de TiO2 rutile et comprend un certain nombre de vides de forme irrégulière formés dans le TiO2 rutile, le nombre de vides de forme irrégulière produisant un second effet de diffusion de la lumière, le second effet de diffusion de la lumière étant égal ou supérieur au premier effet de diffusion de la lumière,
dans lequel les tailles du nombre de vides vont de 50 nm à 900 nm, et
le nombre de particules diffusant la lumière a une densité de tassement de 40 % ou plus dans la couche de matrice de couverture.

2. Substrat d'extraction de lumière selon la revendication 1, dans lequel une épaisseur de la couche de matrice de couverture (130) est comprise entre 10 nm et 500 nm et les diamètres du nombre de particules diffusant la lumière sont compris entre 50 nm et 1 um, et dans lequel l'épaisseur de la couche de matrice de couverture (130) est inférieure aux diamètres du nombre de particules diffusant la lumière.

3. Substrat d'extraction de lumière selon la revendication 1, dans lequel chacune du nombre de particules diffusant la lumière a un indice de réfraction unique ou des indices de réfraction multiples.

4. Substrat d'extraction de lumière selon la revendication 4, dans lequel le nombre de particules diffusant la lumière comprend une combinaison de particules réfringentes uniques ayant un seul indice de réfraction et de particules réfringentes multiples ayant des indices de réfraction multiples.

5. Substrat d'extraction de lumière selon la revendication 5, dans lequel chacune des multiples particules réfringentes comprend un noyau et une enveloppe entourant le noyau, l'enveloppe ayant un indice de réfraction différent de celui du noyau.

6. Substrat d'extraction de lumière de la revendication 1, dans lequel le substrat de base (110) comprend une feuille de verre mince ayant une épaisseur de 1,5 mm ou moins.

7. Dispositif de diode électroluminescente organique comprenant :
une cathode (13);
une couche organique émettrice de lumière (12) empilée sur la cathode;
une anode (11) empilée sur la couche organique électroluminescente; et
le substrat d'extraction de lumière, selon la revendication 1, disposé sur l'anode,
dans lequel la couche de planarisation (140) est en contact avec l'anode (11), et
dans lequel la couche de planarisation, le nombre de particules diffusant la lumière, et la couche de matrice de couverture (130) forment une couche d'extraction de lumière interne.
